Europäisches Patentamt

European Patent Office

Office européen des brevets

(11) Publication number: **0 136 205**
**B1**

# EUROPEAN PATENT SPECIFICATION

(45) Date of publication of patent specification: **01.06.88**

(51) Int. Cl.⁴: **G 01 R 31/28**

(21) Application number: **84401608.9**

(22) Date of filing: **01.08.84**

(54) **Method and apparatus for applying and monitoring programmed test signals during automated testing of electronic circuits.**

(30) Priority: **01.08.83 US 518499**

(43) Date of publication of application:
**03.04.85 Bulletin 85/14**

(45) Publication of the grant of the patent:
**01.06.88 Bulletin 88/22**

(84) Designated Contracting States:
**DE FR GB IT NL**

(56) References cited:
**US-A-4 044 244**
**US-A-4 092 589**

**PATENTS ABSTRACTS OF JAPAN, vol. 7, no. 35(P-175)(1180), 10th February 1983; & JP - A - 57 189 075 (HITACHI) 20-11-1982**

**INTERNATIONAL TEST CONFERENCE 1983, 18th-20th October 1983, paper 8.5, CH 1933-1/83, pages 200-209, IEEE Computer Society, IEEE, USA; R.F. HERLEIN: "Optimizing the timing architecture of a digital LSI test system"**

(73) Proprietor: **FAIRCHILD CAMERA & INSTRUMENT CORPORATION**
**464 Ellis Street**
**Mountain View California 94042 (US)**

(72) Inventor: **Schinabeck, John**
**5266 Muirwood Drive**
**Pleasanton California 94566 (US)**
Inventor: **Murdock, James R.**
**3167 Calzar Drive**
**San Jose California 95118 (US)**

(74) Representative: **Chareyron, Lucien et al**
**Schlumberger Limited Service Brevets c/o Giers**
**12, place des Etats Unis B.P. 121**
**F-92124 Montrouge Cédex (FR)**

Courier Press, Leamington Spa, England.

**0 136 205**

**Description**

Background of the invention

This invention relates to electronic circuits and, more particularly, to general purpose test systems capable of testing very large scale integrated (VLSI) circuits, including microprocessors, lgic arrays, and multi-chip assemblies, at high speeds. Specifically, the invention is directed to a method and apparatus for automatically testing one or more electrical properties of a series of electronic circuits by applying and monitoring test signals during testing of the electronic circuits in an automated electronic test system.

In automated electronic test equipment, one or more electrical signal sources is coupled to the pins or other nodes at the inputs of an electronic device being tested to force stimuli signals controlled by a test system computer onto the device under test, and the resultant conditions at the outputs of the device being tested are monitored. Typically, the stimuli signals represent logic states or analog voltages or currents which are applied in a parallel pattern to the input pins of the device under test, and the resulting output pattern is checked in parallel.

The signal sources apply stimuli signals to the device under test through pin electronics interface circuits which function as computer controlled interface circuits between the computer of the test system and the individual pins of the device being tested. The pin electronics interface circuits receive these stimuli signals and then through input drivers included in the pin electronics interface circuits switch these stimuli signals onto the desired input pins of the device under test in accordance with a stored program in the test system. The pin electronics interface circuits also receive reference voltages or currents which comparator circuits included in the pin electronics interface circuits compare to the voltages or currents received from the output pins of the device being tested. The output signals from the comparator circuits are returned to the test system computer where they are checked in accordance with a stored program for the proper responses. In this manner, electronic components, for example, semiconductor memories or other integrated circuits, can be individually tested to assure that they meet whatever standard or specifications the ultimate user of the integrated circuit desires.

Considered in more detail, known static measurement circuitry has a single voltage or current force mode programmable precision measurement unit connected to the input pins of the device being tested via a relay matrix included in the pin electronics interface circuits. Single limit analog comparison techniques are typically used for go/no-go measurement speed. Measured value results are generally acquired via a software search routine. In some automated electronic test equipment, the constant voltage signal source can be reconfigured for constant current operation. Mode reconfiguration switching and low current ranges typically limit analog speed to that required to maintain stable operation with a maximum specified capacitive load. One disadvantage in the operation of such automated electronic test equipment, however, is the voltage transients caused by reconfiguration which result in disturbances in the operation of the automated electronic test equipment. Relay switching during configuration change while connected to the device under test causes aberrations due to the disturbances caused by the voltage transients.

Bias supplies used as the signal sources have traditionally been digitally programmed bipolar operational power amplifiers. Another disadvantage in the operation of such automated electronic test equipment, however, is the destruction of the evidence of failure of the device under test.

Some form of voltage clamping is typically provided in the current force mode to protect the device being tested from compliance voltage, but only when sequencing the precision measurement unit connection from one input pin to the next. Programmable current clamps are occasionally included, but the only limit on power delivered to the load is typically a hardware self protect mechanism.

As circuits increase in density and gate count, they become more of a power sink or load source. This causes concern when the device under test has a tendency toward short circuit if the device is defective. The automated electronic test equipment can destroy the evidence of failure.

While known precision measurement units have some capability to respond to sudden current demand changes, their worst case compensated slow dynamic response can cause damaging transients to occur. Sensing of an out of tolerance condition when a device being tested is powered up provides the desired early fail indication, but without fast power limiting, destruction of fail evidence and/or the device under test to precision measurement unit connection path can result.

United States Patent 4,092,589, issued May 30, 1978 shows high speed testing circuitry for integrated circuits having a digitally programmed source means connected to a node by a first switch means and a comparison means connected to a node by a second switch means.

Summary of the invention

The present invention provides a method and apparatus for applying static analog voltages or currents to pins of a device under test and monitoring or measuring resulting currents or voltages so as to evaluate the responses of the device being tested. In one embodiment an automatic crossover forcing function for supplying test signals to provide a minimum disturbance when the device being tested is connected and to protect against destruction of the evidence of failure when the device under test is out of tolerance, that is, defective. Also provided is a programmable voltage and current values which define a pass window to assure a non-ambiguous go/no-go result during testing.

In one embodiment, a method and apparatus are provided for automatically applying and monitoring

2

forcing functions to a device being tested. The method and apparatus in accordance with the invention provide gated voltage-current crossover forcing functions for test signals. This provides a minimum disturbance when the device under test is connected.

One embodiment provides a method for applying and monitoring a test signal at a node of a device under test including digitally programmed source means having a preselected programmed voltage-current characteristic defined by not-to-exceed voltage rail and current rail levels switchably connected by a first switch means to the node for supplying a test signal to the node and comparison means switchably connected by a second switch means to the node. The method comprises the steps of: connecting the test signal to the node; comparing the test signal with a preselected programmed reference level; providing an indication of the relative magnitude of the test signal with respect to the preselected programmed reference level; and providing a preselected programmed constant signal in the event that the test signal has a predetermined relationship with respect to the preselected programmed reference level.

In accordance with another aspect of the invention, an embodiment of apparatus for applying and monitoring a test signal to a node of a device under test is provided. The apparatus comprises: digitally programmed source means switchably connected by a first switch means to the node, the digitally programmed source means having a preselected programmed voltage-current characteristic defined by not-to-exceed voltage rail and current rail levels for supplying test signals and alternatively a preselected programmed constant signal to the node; and comparison means switchably connected by a second switch means to the node for indicating the relative magnitude of the test signal with respect to a preselected programmed reference level; the digitally programmed source means supplying the test signals unless the test signal applied has a predetermined relationship with respect to the preselected programmed reference level; the digitally programmed source means supplying the preselected programmed constant signal in the event that the applied test signal has a predetermined relationship with respect to the preselected programmed reference level.

Additionally, the invention provides a method for monitoring the response signal at a node of a device under test caused by a test signal applied to the node by digitally programmed source means having a preselected programmed voltage-current characteristic defined by not-to-exceed voltage rail and current rail levels switchably connected by a first switch means to the node and comparison means switchably connected by a second switch means to the node. The method comprises the steps of: connecting the test signal to the node; comparing the response signal voltage at the node with a first preselected programmed voltage level; comparing the response signal voltage at the node with a second preselected programmed voltage level; comparing the response signal current at the node with a first preselected programmed current level; comparing the response signal current at the node with a second preselected programmed current level; providing an indication of the relative amplitude of the response signal voltage and current with respect to the first and second preselected programmed voltage levels and first and second preselected programmed current levels, respectively; providing a pass signal when the response signal voltage and current have a first predetermined relationship with respect to the first and second preselected programmed voltage levels and first and second preselected programmed current levels, respectively; and providing a fail signal when the response signal voltage and current have a second predetermined relationship with respect to the first and second preselected programmed voltage levels and first and second preselected programmed current levels, respectively; thereby providing a non-ambiguous pass/fail result. Preferably, the test signal is a forcing function which starts at zero volts and one percent of the maximum current of a preselected voltage-current range.

One embodiment provides apparatus for monitoring the response signal at a node of a device under test caused by a test signal applied to the node. The apparatus comprises: digitally programmed source means switchably connected by a first switch means to the node, the digitally programmed source means having a preselected programmed voltage-current characteristic defined by not-to-exceed voltage rail and current rail levels for supplying test signals to the node; first comparison means switchably connected by a second switch means to the node for indicating the relative amplitude of the response signal voltage at the node with respect to a first preselected programmed voltage level; second comparison means switchably connected by the second switch means to the node for indicating the relative amplitude of the response signal voltage at the node with respect to a second preselected programmed voltage level; third comparison means switchably connected by the second switch means to the node for indicating the relative amplitude of the response signal current at the node with respect to a first preselected programmed current level; fourth comparison means switchably connected by the second switch means to the node for indicating the relative amplitude of the response signal current at the node with respect to a second preselected programmed current level; means for providing a pass signal when the response signal voltage and current have a first predetermined relationship with respect to the first and second preselected programmed voltage levels and first and second preselected programmed current levels, respectively; and means for providing a fail signal when the response signal voltage and current have a second predetermined relationship with respect to the first and second preselected programmed voltage levels and first and second preselected programmed current levels, respectively; whereby a non-ambiguous pass/fail result is provided. Preferably, the digitally programmed source means is a crossover source which supplies a test signal in the form of a forcing function that starts at zero volts and one percent of the maximum current of a preselected voltage-current range.

3

The digitally programmed source can provide a gated, automatic crossover type forcing function. Since the device under test can present a power sink or source load, a four-quadrant operation is provided.

The digitally programmed source can be gated on and off. Voltage and current are independently gated to provide a minimum disturbance connect-disconnect condition with dry switching of relays. This allows direct connection of the Kelvin force and sense paths to a laod board point near the pin of the device under test to be biased without a relay disconnect provision. The idle (gate-off) state is preferably forcing zero volts with current rails set at one percent of full scale in the last programmed range.

The digitally programmed source can be programmed with signed values of voltage and current to define two calibrated operating rails in the intended operating quadrant. An equal valued uncalibrated current rail in the opposite quadrant is automatically set by the circuitry to limit maximum power that can be delivered to the device being tested. The connected device under test load determines a stable operating point (typically on the calibrated current or voltage rail) which can be digitized by on-board analog-to-digital converters after a programmed settling delay. On-board analog-to-digital converters provide simultaneous conversions of the voltage and current operating point. The dynamic characteristics are under program control to optimize test system throughput. Program selected rolloff allows the test plan to control optimum speed for each test condition.

The force lines can be open circuited by a relay under program control. In this configuration, the sense input can be routed as a high impedance voltmeter probe via the connect paths. The dedicated voltage and current analog-to-digital converters can digitize measurements and return the values for software use. Also, four voltage and current limit registers can be loaded to define a pass window, and the measurements can be compared to these programmed high and/or low limits to return a direct pass/fail result.

A four-quadrant, automatic crossover test signal source can be provided which is programmed in both current and voltage. When the test signal source is connected to the device under test, the resulting load determines a stable operating point on the programmed constant voltage or current rail. Thus, the maximum power delivered is controlled by the test plan, rather than by clamp type protection mechanisms or a test system self protect mechanism.

The method and apparatus in accordance with the invention allow a minimum disturbance connection to the device under test and limit the power delivered to a defective device being tested so as not to destroy the evidence of failure. On-board analog-to-digital converters are provided for measured value results of the test signal source operating point voltage and current which are preferably compared against programmed reference levels or limit values for a pass/fail condition. This provides a more sensitive indication when abnormal current demand change occurs during functional testing. The method and apparatus in accordance with the invention can be used for engineering characterization, production testing, incoming inspection, and quality assurance of complex integrated circuits, such as VLSI circuits.

Brief description of the drawings

The above and other features of the invention and the concomitant advantages will be better understood and appreciated by those skilled in the art in view of the description of the preferred embodiments given below in conjunction with the accompanying drawings. In the drawings:

Fig. 1 is a block diagram of a test system fabricated according to the invention;

Fig. 2 is a more detailed block diagram of the testing circuit of this invention;

Fig. 3 is a schematic circuit diagram of the precision measurement units included in the testing circuit shown in Fig. 2;

Fig. 4 is a detailed schematic circuit diagram of the analog circuitry included in the digitally programmed sources of the precision measurement units included in the testing circuit shown in Fig. 2; and

Fig. 5 illustrates the voltage-current characteristics of the digitally programmed sources of the precision measurement units included in the testing circuit shown in Fig. 2.

Description of the preferred embodiments

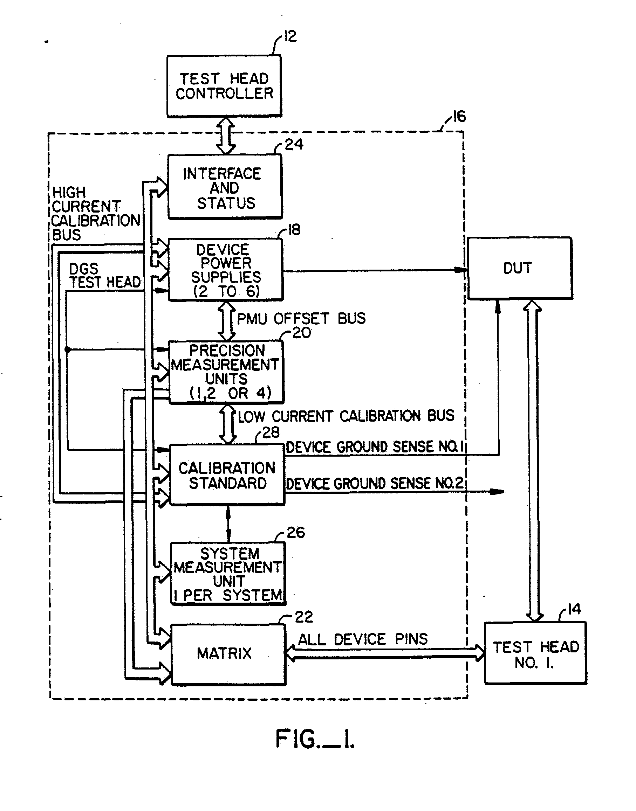

Fig. 1 is a block diagram of a test system fabricated according to this invention. Shown in Fig. 1 is a test head controller 12. The test head controller 12 is preferably implemented with a dedicated 68000 microprocessor manufactured by Motorola Inc. of Phoenix, Arizona coupled with program and data random access memory (RAM) and 16 Kilobytes of bootstrap programmable read only memory (PROM). The test head controller 12 transmits control data and receives subsystem status reports, interrupt requests, and test data. The test head controller 12 is responsible for all communications between the test program and the testing circuit, with the exception of the down loading of test vectors which are handled by a test vector store (not shown). One test head controller 12 is provided for each test head 14.

Each test head controller 12 interfaces to a direct current (DC) subsystem 16 associated with the test head 14. One dedicated DC subsystem 16 is preferably provided for each test head 14. Output to the test head 14 is timed-formatted drive data (for inputs) and expect data and strobe timing (for outputs). Information received from the test head 14 is pass/fail data resulting from output comparisons.

The major functional components of the DC subsystem 16 include: two to six device power supplies 18 used to supply static bias power to the device under test (DUT); one, two, or four precision measurement units (PMU's) 20 for voltage and current test stimulus and DUT static parameter measurements or limit tests; a guarded Kelvin relay matrix 22 for interconnection of the PMU's to the test head 14; an interface bus 24 to transfer control and status information between the DC subsystem and the dedicated test head controller 12; and a system measurement unit 26 and calibration standard circuit 28 used for automatic calibration of the test head and DC subsystem.

The DC subsystem 16 preferably includes the system measurement unit 26 and calibration standard circuit 28 for automatic test system calibration. The calibration standard circuit 28 has National Bureau of Standards traceable precision voltages and resistances that are used in conjunction with the system measurement unit 26 to automatically calibrate the test head 14 and DC subsystem 16 analog voltages. There is preferably one system measurement unit 26 and calibration standard circuit 28 in each test system, and they can be shared by as many as two DC subsystems 16 if two test stations are present.

The test system is configured in a modular fashion and can be expanded on a functional basis (more device power supplies 18 or PMU's 20) or by adding an additional test head 14. The DC subsystem 16 includes the device power supplies 18 and PMU's 20 for DC parametric tests. Each DC subsystem 16 can be configured with a varying number of device power supplies 18 and PMU's 20 to suit the individual DUT testing needs.

The DC subsystem 16 preferably includes a minimum of two device power supplies 18. Additional device power supplies 18 can be added, in increments of two, for a maximum of six device power supplies per DC subsystem 16. The device power supplies 18 provide high current (eight ampere) capability and swings of up to 32 volts (V) to supply the current requirements of the largest bipolar gate arrays.

One PMU 20 is included in the DC subsystem 16, and additional PMU's can be added to a maximum of four. Simultaneous use of four PMU's 20 results in increased speed for faster DC parametric tests. The PMU's 20, in contrast to the device power supplies 18, provide high voltage and high current (100 V/256 milliamperes) at high accuracy and can be connected to all pins of the DUT. Each PMU 20 can make measurements relative to device ground, or relative to any of the device power supplies 18 for such tests as $V_{OH}$.

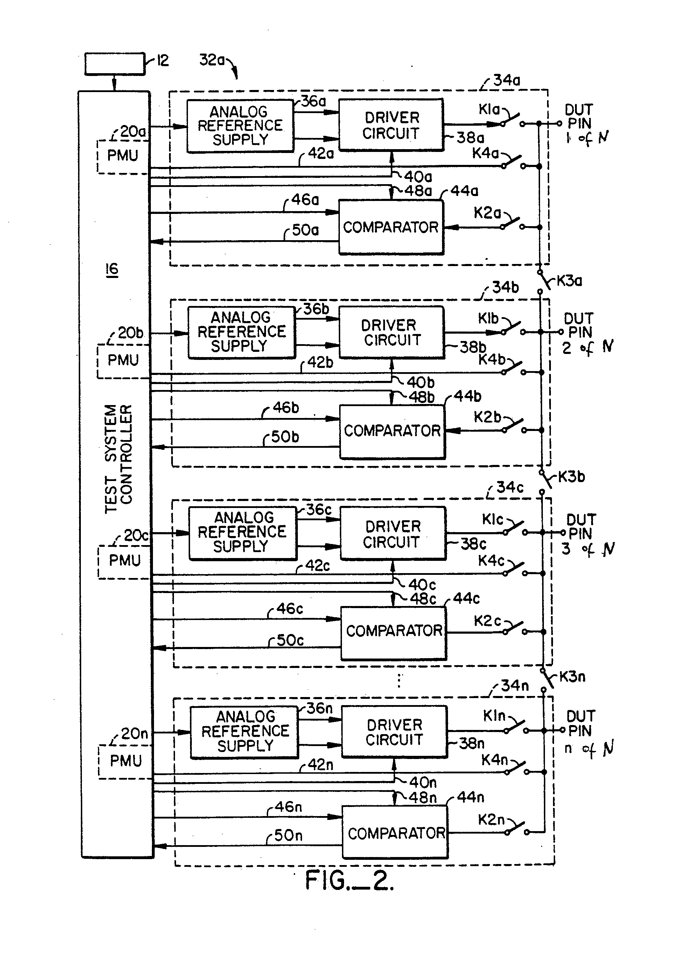

The PMU's 20 are connected by the relay matrix 22 to the test head 14 and via a plurality of pin electronics interface circuits included in the test head to the DUT as will be described in conjunction with Fig. 2. The PMU's 20 shown in Fig. 1 provide precision DC parameter tests over a greater range of current and voltage than is provided by per pin tests via the pin electronics interface circuits. Each pin electronics interface circuit includes circuitry for four DUT pins. All four channels are identical, and all are full input/output (I/O) channels.

The test system can support one or two test heads 14, either a 128-pin configuration or a 256-pin configuration. The test head 14 is expandable from a 64-pin base in 32-pin increments. The test head 14 comprises the pin electronics interface circuit drivers, pin electronics interface circuit comparators, programmable current load, pin electronics interface circuit relays, pin electronics interface circuit reference generators, per pin measurement circuitry, and DUT interface circuitry. Each channel has: a two-level driver with a high impedance (off) state; four-level comparators for V high, V low, and V intermediate pairs; and a low-capacitance programmable load that is also capable of providing a 50-ohm termination for ECL device testing with a low reflection coefficient.

The drivers, comparators, and programmable loads have dedicated digital-to-analog converters (DAC's), a total of nine DAC's per pin for complete flexibility. This flexibility provides programming ease and mixed-mode logic on multi-chip assemblies. This flexibility is a key to maintaining DC accuracy with automatic calibration compared to known automated electronic test equipment.

The relay matrix 22 is a high-quality, low-leakage relay matrix used to switch outputs from the PMU's 20 to the DUT via the pin electronics interface circuits and allows force, sense, and guard lines of the PMU's to be connected to any pin of the DUT. The relay matrix 22 is configured to allow access to all pins in a test system with one PMU 20. In a test system with two PMU's 20, all odd pins are preferably connected to PMU 1, and all even pins are connected to PMU 2. In a test system with four PMU's 20, the pins are preferably connected to the PMU's in a modulo-four manner, i.e., PMU 0 to pins 0, 4, 8, . . ., PMU 1 to pins 1, 5, 9, . . ., PMU 2 to pins 2, 6, 10, . . ., and PMU 3 to pins 3, 7, 11, . . .. The relay matrix 22, however, can be reconfigured so that any PMU 20 can be assigned as 0 or 1 to allow reassignment and continued testing if one PMU fails. The device power supply 18 high-sense lines and device ground sense are also relay switched to the PMU 20 low-sense lines for PMU offsetting and effective differential measurements. The interface bus 24 is the communication circuit between the DC subsystem 16 and test head controller 12 over which the DC subsystem receives information from and sends information to the test head controller.

The test system uses dedicated DC subsystem circuitry for each test head 14. Thus, while DC tests are being executed at one test station, either functional or DC testing can occur simultaneously at the optional second test station. These tests are independently controlled by the dedicated test head controller 12.

On the one hand, the device power supplies 18, which form a high voltage test station, allow each test pin, under the control of programmed instructions, to be assigned as a bias supply. The force and measure amplitudes handled by the device power supplies 18 are greater than those handled by the test head controller 12 and PMU's 20, but such speed considerations as rise and fall time are necesarily slower.

On the other hand, the test head controller 12 and the PMU's 20 allow DC parameter tests. The test head controller 12 and PMU's 20 include the capability for each active test pin, under the control of programmed instructions, to be assigned as an input driver, output comparator, or I/O pin. A timing module offers timing edge resolution, which allows the user to accurately place edges when measuring the alternating current (AC) parameters of a high speed DUT. The test rate is programmable. The uninterrupted flow of timed test vectors between the test head controller 12 and the DUT emulates combinations to which the DUT would be subjected in its intended application.

Fig. 2 is a more detailed block diagram of a portion of each test signal applying and monitoring circuit 32 in accordance with this invention. As shown in Fig. 2, a test signal applying and monitoring circuit 32a communicates with the test head controller 12 via the interface bus 24. The test head controller 12 controls the pattern of test signals applied to the DUT by the test signal applying and monitoring circuit 32a. Several registers within the test head controller 12 allow control of each DUT pin while testing at the programmed rate.

The test signal applying and monitoring circuit 32a includes a plurality of pin electronics interface circuits 34a, 34b, 34c, . . ., 34n connected to n pins of the DUT. Preferably, one pin electronics interface circuit 34 is connected to each terminal of the multi-terminal DUT. Each pin electronics interface circuit 34 is capable of being operated by the test head controller 12 in one of several modes depending upon whether the pin electronics interface circuit is coupled to a DUT input signal terminal, DUT output signal terminal, or other various function or supply terminals. Thus, a DUT having sixteen terminals or pins is tested in a fixture containing sixteen identical pin electronics interface circuits 34 controlled by a single test head controller 12 containing a stored program specifically written to test the particular DUT.

For example, to functionally test a signal input terminal of the DUT, the test head controller 12 closes a relay contact K1a, for example, a reed relay contact, included in the pin electronics interface circuit 34a to connect the test stimuli section of the test signal applying and monitoring circuit 32a to pin 1 of the DUT. This section of the test signal applying and monitoring circuit 32a includes an analog reference supply 36a which in response to signals from the test head controller 12 generated according to a program stored in the test system computer produces two levels of direct current reference signals. These two reference signals are applied to a driver circuit 38a which biases the DUT between the two reference signals to produce a pattern of pulses for functional testing in accordance with data supplied to the driver circuit on a line 40a.

The test signal applying and monitoring circuit 32a is also capable of performing parametric tests on the DUT. As will be decribed in greater detail, the test signal applying and monitoring circuit 32a in accordance with the invention is particularly directed to parametric tests on the DUT. During one case of such testing, the PMU 20a located within the DC subsystem 16 supplies desired voltages or currents to the appropriate pin of the DUT. In such operation, the test head controller 12 closes only relay contact K4a, for example, a reed relay contact, to enable coupling of pin 1 of the DUT to the PMU 20a via a line 42a. Similar PMU's 20b, 20c, . . ., 20n can apply controlled test signals to corresponding other pins of the DUT, or one or more PMU's can be multiplexed to the pins.

For quantitative voltage or current measurement, each PMU 20 can be used to apply (force) a precision program specified voltage or current to any desired pin of the DUT. Each PMU 20 preferably provides force and measurement ranges up to +100 volts (V) volts and 256 milliamperes (mA).

In accordance with the invention, each PMU 20 includes a digitally programmed source which provides a gated, automatic crossover type forcing function. Since the DUT can present a power sink or source load to a connected PMU 20, four-quadrant operation is preferably provided. The digitally programmed source included in each PMU 20 can be gated on and off. Voltage and current are independently gated to provide a minimum disturbance connect-disconnect condition with dry switching of relays.

The idle (gate off) state is preferably forcing zero volts with current rails set at one percent of the last programmed range. Program selected rolloff allows the test plan to control optimum speed for each test condition.

The test head controller 12 can close a relay contact K2a, for example, a reed relay contact, so that the test signal from the PMU 20a coupled to the signal input terminal of the DUT is applied directly to a comparison means 44a. The comparison means 44a included in the PMU 20a preferably comprises on-board analog-to-digital converters (ADC's) for simultaneous conversions of the voltage and current operating point. The comparison means 44a can also receive a predicted signal from the test head controller 12 via a line 46a. Consequently, the output signals from the comparison means 44a can change in accordance with the test signal applied to the DUT.

In addition, a data input signal can be transmitted by the test head controller 12 to the comparison means 44a through a line 48a to switch the output signals from the comparison means. The output signal from the comaprison means 44a is returned to the test head controller 12 via a line 50a. The output signal from the comparison means 44a on the line 50a can cause the test head controller 12 to register either acceptance or rejection of the DUT, or to specify its quality.

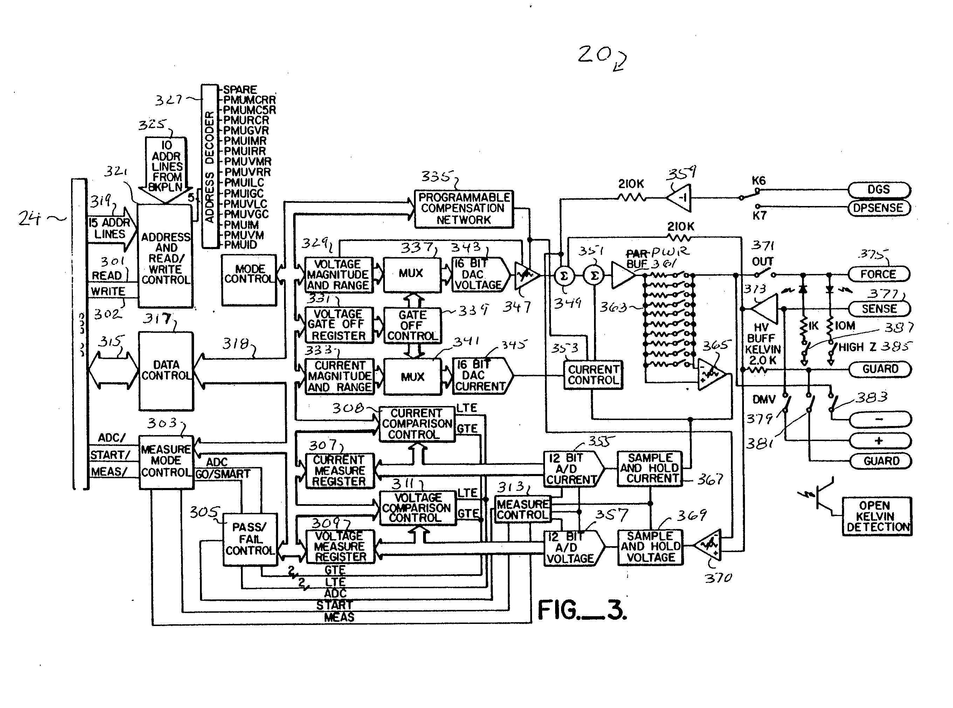

Fig. 3 is a more detailed schematic circuit diagram of a portion of each of the test signal applying and monitoring circuits 32 in accordance with the invention. Each PMU 20 includes a digitally programmed source which provides a four-quadrant, gated current or voltage forcing function. The PMU 20 is a programmable precision voltage or current supply which can force a constant voltage or clamp to a constant current. Each PMU 20 also includes on-board comparison means 44 in the form of analog-to-digital converters (ADC's) for simultaneous measurement of the voltage and current operating point. The

6

PMU 20 can be referenced to device ground sense (DGS) or any device power supply 18 in the same DC subsystem 16. This load current or voltage can be measured with an ADC and read back for a numerical result or compared against a programmed limit value for a pass/fail condition.

The PMU 20 can be used either as a high impedance voltmeter or an ammeter to accurately measure both voltage and current at any pin of the DUT simultaneously. While each PMU 20 can either force voltage or current, the PMU can simultaneously measure both voltage and current output to the DUT. The PMU 20 is calibrated by the system measurement unit 26 and calibration standard circuit 28.

The PMU 20 can be connected differentially and measure between any pin and DGS or between any pin and the high sense line of any device power supply 18. The PMU 20 can make measurements in three modes: (1) measurement mode; (2) analog settling analysis mode; and (3) go/no-go measurement mode.

The PMU 20 is an extremely flexible power supply with the capability of being fully programmable, with respect to both voltage and current, and having the ability to program the response characteristic time to optimize the test time. As shown in Fig. 3, all input and output signals are through edge connectors to the DC subsystem 16 backplane. There are 16 data lines 315 and 15 address lines 319 supplied from the pin electronics interface circuit board. The analog inputs and outputs can be disconnected from the backplane by relays included in the PMU 20.

There are two 16-bit digital-to-analog converters (DAC's) 343, 345 included in the PMU 20, one 343 for forcing voltage and one 345 for forcing current. The outputs of these DAC's are used together to provide control over the forcing and clamping circuitry. The measurement ability of the PMU 20 is performed by two 355, 357 12-bit ADC's and the measurement control circuitry. All functions of the PMU 20 are externally programmable by the user.

The PMU 20 includes a digital section, starting with the address decoder block 327. The primary function of this block is to decode the board and the register selects. There are 14 separate registers included in each PMU 20. The board select and individual register selects are decoded from the 10 address lines from the backplane 325 (built into the backplane) and the 15 address lines 319 sent to each PMU 20 from the interface bus 24 included in the DC subsystem 16.

The PMU 20 also includes an address and read/write control block 323. This block contains the address interface and the read/write control circuitry. Inputs to this block are the read 301 and write 302 signals from the interface bus 24 included in the DC subsystem 16 and the 15 address lines 319 from the interface bus 24 included in the DC subsystem 16. Each PMU 20 has a separate identification (ID) register. This register contains the identification code for the board and the register for the status indicators for the board. The following description is of the ID register: bit 0 is always 1 and indicates whether a circuit board is plugged in or not. This bit is a read only bit. Bits 1—5 contain the assembly revision number. Bits 6—13 are not used. Bit 14 controls an amber LED for diagnostics display and is a read/write bit. Bit 15 controls a red LED for diagnostics display and is a read/write bit. The LED codes are shown in Table I.

TABLE I

LED CHART

| AMBER | Untested |
| AMBER/RED | One of several in a failure test |
| RED | Faulty module |
| ALL OFF | Ready for use |

The data control block 317 is a bidirectional data bus which allows communications between the PMU 20 and the interface bus 24 included in the DC subsystem 16. The data bus 318 is 16 bits wide and common to all registers included in the PMU 20.

Various blocks are associated with the voltage and current DAC's. The voltage magnitude and range 329 and the current magnitude and range 333 are functionally identical, with the results being the digital control of the respective DAC's 343, 345. However, the mux blocks 337, 341 must already be in the gate-on condition. If the gate-off condition is in effect, then the inputs to the DAC's are from the gate-off control block 339. In the gate-off mode, the voltage DAC is programmed to an uncalibrated zero volts. The current DAC is programmed to one percent of range. There are separate gate on/off controls 331 for voltage and current, thereby allowing flexibility in the output conditions of the PMU 20.

The analog section is divided into three major sections. First is the forcing circuitry, second is the clamping circuitry, and finally the measure circuitry.

The forcing circuitry comprises the following sections: 16-bit voltage DAC 343 (dependent on mode); 16-bit current DAC 345 (dependent on mode); summing nodes 349, 351; power buffer 361; current range resistor network 363; and high voltage buffer (sense) 373. In the voltage force mode, the 16-bit voltage DAC 343 supplies the correct potential to the summing point 349 via the variable gain amplifier 347. The amplifier 347 is voltage range dependent. This amplifier 347 can also be compensated (by 335) to optimize the test conditions to increase throughput in the production environment. The compensation consists of changing the response time and therefore increasing or decreasing the bandwidth of the circuit, at the expense of reducing capacitive load. At the first summing point 349, the DAC voltage is referenced to the input signal PREF which has its own inverting unity gain buffer 359. This allows the PMU 20 to be referenced to the device power supply 18 sense line. At the first summing point 349, the feedback from the high voltage sense buffer 373 is also summed. The output is summed in the second summing point 351 with the output optimized to increase throughput. The output of the second summing point 351 is fed to the input of the high power buffer 361. The output of the buffer then goes through the current ranging resistors 363 and through the output relay 371 to the force line 375 coupled to the matrix board. At the test head 14, the force line 375 is tied to the sense line 377, and the forced voltage is present at the input of the high voltage sense buffer 373. The output of the sense buffer 373 feeds back through a feedback resistor 360 to the first summing point 349, thereby completing the forcing loop.

In the current force mode, the 16-bit current DAC 345 supplies the correct potential to the current control block 353. The other input to this block is from the current monitoring amplifier 365 that senses the current through the current range resistors 363. The output of the current control block 353 is fed to the second summing point 351 to combine with the voltage that is sent from the voltage DAC 343. As the current forcing value is reached, the current control block 353 starts limiting any further increase in current. Otherwise, the output voltage would drop proportionately.

The clamping circuitry comprises the following blocks: current monitor buffer 365; current control block 353; current ranging resistors 363; and 16-bit current DCA 345. To force a voltage and clamp at a specific current level the voltage magnitude and range and current magnitude and range must be initially set up (proper output connections are assumed).

If the load resistance is low enough to cause more current to flow through the current ranging resistors than has been programmed into the current DAC 345, then the current control circuitry reacts to this condition and reduces the output voltage accordingly so that the current through the ranging resistors decreases to the limit set into the current magnitude DAC. This is also the same procedure for forcing current.

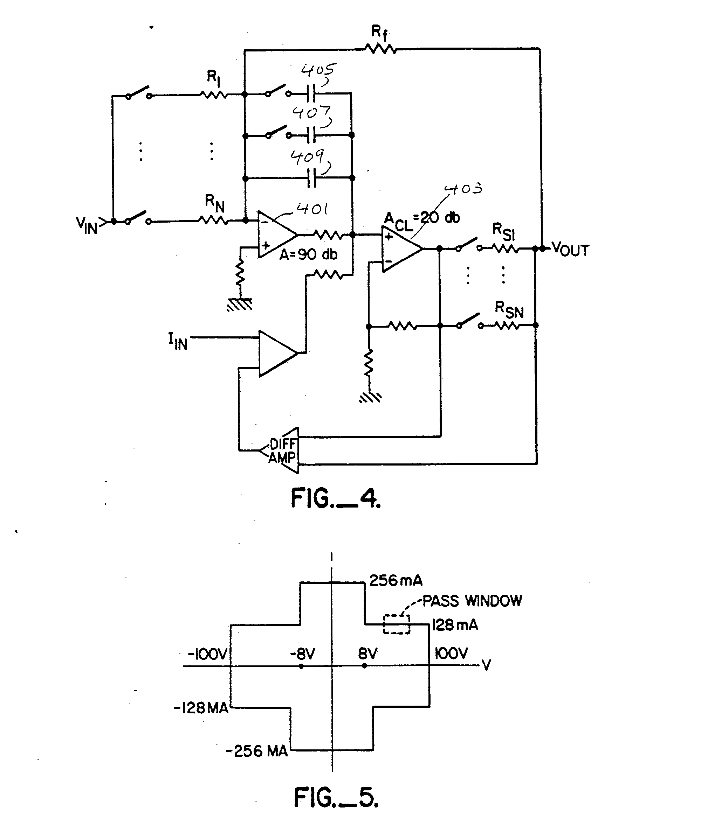

The analog circuitry starts at the DAC outputs. The circuit is a precision voltage amplifier with high current capability. However, the amplifier switches to a precision current source whenever the load current exceeds a programmed limit. A block diagram of the amplifier is shown in Fig. 4. The operation will be discussed in two phases: a) operation as a voltage amplifier; and b) operation in current clamp.

The voltage amplifier 401, 403 is a feedback amplifier whose gain is primarily dependent on external components. The closed loop gain of this amplifier, V out/V in, is equal to Rf/Rn (Rn is one of the input resistors which is switched in to set the voltage range). The DC open loop gain is high enough (greater than 100 dB) to assure the accuracy of the closed loop gain. The first stage of the amplifier is a ua 356. This stage is connected as an integrator to provide a dominant pole for the loop. The capacitor 409 from output to input sets the loop bandwidth and thereby the settling time for the amplifier. Two additional capacitors 405, 407 can be switched in to maintain stable operation when capacitive loading is heavy.

The second stage 403 is a discrete amplifier with ±256 mA drive capability. The gain of this stage is also controlled by feedback resistors and is set at 20 dB.

As long as load current does not exceed the programmed limit, the current clamp does not affect circuit operation. Load current is constantly monitored via a current sense resistor, Rsn, at the output of the voltage amplifier. Whenever the current through Rsn exceeds the programmed value, the first stage of the voltage amplifier is forced into cutoff, and a current driver integrator controls the closed loop operation.

The last section is the measure circuitry. The following blocks comprise the measure circuitry: measure mode control 303; pass/fail control 305; measure control 313; current measure register 307; voltage measure register 309; current comparison control 308; voltage comparison control 311; two 12-bit ADC's 355, 357; two variable gain amplifiers 365, 370; and two sample and hold circuits 367, 369.

The measure circuitry is primarily comprised of two distinct measurement circuits. With these two circuits, both voltage and current can be measured simultaneously. The voltage to be measured is derived from the output of the sense line buffer 373 into a variable gain amplifier 370 and then into the sample and hold circuit 369. Correspondingly, the current measurement is derived from the resulting voltage drop across the ranging resistors 363, which is also fed into a variable gain amplifier 365. The gain of these amplifiers is controlled by the respective range control circuitry included in the forcing circuitry. The measurements are in the same ranges that have been programmed into the forcing circuitry.

There are two sets of limit registers included in the two separate measurement circuits. Each set has a high and a low comparison register. Each of these registers can be programmed to compare against either less than, greater than, or neither (masked). With the values that can be programmed into magnitude for comparison and the parameters that can be programmed to compare against, the window of the comparison can be almost any shape or value. For example, any or all of the limits can be masked. Also, any comparison register can hold any value in the range dictated by the forcing circuitry. Further, comparisons can mean either pass or fail.

When loading calibrated values for each active digital-to-analog converter (DAC) 343, 345, the test head controller 12 employs a dedicated calibration processor. With this configuration, an accurate measured value or indication is attained by first parallel loading a selected DAC register with an uncalibrated start value. Next, all test associated DAC registers are incremented to the force value. As the voltage at any pin crosses a preset compare level, the contents of the DAC register are latched.

The test is completed after all participating pins have crossed the pass/fail boundary. At this time a read of stored values by the dedicated calibration processor can return accurate measured values.

8

The measure control block supplies the proper signals to control all of the states of the sample and hold 367, 369 and the ADC 355, 357. Primarily the sample and hold receives a 5 μs pulse for the sample mode, and then three 500 ns pulses are generated to control the synchronous strobing of the data to be compared, start conversion pulse, and a 500 ns delay period, respectively. The measure control block also AND's the complete status bits together to signal the remainder of the measure control circuitry after both of the conversions are completed. The measure control block starts its sequence by either having the START or the MEAS signals go active.

When the measurement conversions are complete, the pass/fail control block 305 and the measure mode control block 303 determine what response, if any, to send back to the interface bus 24. If a measurement mode is in effect, then when the conversions are complete, the ADC/signal goes active, indicating to the test head controller 12 that the measurement cycle is complete and the measure DATA is ready to be read. If the analog settling analysis mode is in effect, then the measure mode control 303 and the pass/fail control 305 circuitry determine if the comparison criteria had been met to stop the measurement or not. If the criteria had been met, then the resulting ADC/signal to the interface bus 24 signals the test head controller 12 that the test is complete. This can signify either a pass or a fail. In the last case of measurement modes, the go/no-go measurement mode, the sequence is the same as in the measurement mode, but the ADC/ sent to the interface bus 24 indicates a pass or a fail.

A measurement requires just one measurement with no comparison. A go/no-go measurement requires one measurement with comparisons determining the results. An analog settling analysis takes multiple measurements until a comparison limit is reached or a time out occurs.

The following is a brief description of how the relays included in the PMU 20 react to stimulus. The DMV relays 379, 381, 383 are normally open and close when the system measurement unit 26 is to make a voltage measurement on the PMU 20. The output relay 371 is normally open and must be closed to connect the PMU 20 to the relay matrix 22. The high Z relay 385 is a normally closed relay and must be opened to make a high Z measurement. The Kelvin check relay 387 is a normally open relay and must be closed to force the Kelvin alarm circuitry to activate. The Kelvin alarm circuitry is activated when approximately 2 V exists across the diodes in the force and sense lines. Of the last two relays, there is a normally closed relay K6 that is normally closed on the DGS reference and a normally open relay K7 that is closed on DPSENSE when in the opposite state. That is, when DPSENSE is selected, the relay contact K7 is closed, and the relay contact K6 is open. To select DGS, the opposite is the case.

The calibration of the PMU 20 is accomplished through the use of the system measurement unit 26 and calibration standard circuit 28. The PMU 20 is connected to precision load resistors via a calibration bus (not shown). The precision load resistors are voltage sensed by the system measurement unit 26. As the PMU 20 forces voltages to the load resistors, the system measurement unit 26 measures the values. It is these values that are acted upon by the calibration program. The same procedure is used to calibrate the current forcing mode of the PMU 20. It is therefore noted that the accuracy of the calibrated PMU 20 is determined by the calibration accuracy of the system measurement unit 26.

In the fastest settling time (27 μs), the current ranges are between the 256 mA and the 2 mA ranges. The next settling time is the 1 ms range, and the current ranges are between the 256 mA and 16 μA ranges. The next settling time is 10 ms, the current ranges are within the 256 mA and the 2 μA ranges. The last settling time is 100 ms, and the current ranges are 256 mA to 500 nA ranges. The 27 μs range is hardwired, but the other three ranges are programmable, with their corresponding bits in the relay control register. These values are based on 250 picofarads (pf) for the cable capacitance, 200 pf for the DUT/mother board interconnect, and up to 1000 pf added capacitance to the DUT.

A guarded Kelvin connect path form each PMU 20 to the pin electronics interface circuits 34 is provided by the low-leakage relay matrix 22. The connection path to the DUT is preferably restricted to a modulo 2 or modulo 4 pin connection (i.e., PMU 0 to pins 0, 4, 8, 12, . . ., PMU 1 to pins 1, 5, 9, 13, . . ., etc.) when two or four PMU's 20 are installed.

The pin electronics interface circuits 34 include the connect relays for the PMU 20. The connect relays are used to connect the PMU 20 to the DUT pin. The PMU 20 driven guard terminates on the pin electronics interface circuit board at the connect relays. The Kelvin force to sense is terminated by one of the relays.

In operation, the voltage of the digitally programmed source included in the PMU 20 is gated on to pre-condition or pre-charge the capacitance of the testing circuit. Then the digitally programmed source included in the PMU 20 is connected to the DUT. Only then is the current of the digitally programmed source included in the PMU 20 gated on. This provides a minimum disturbance connection to the DUT.

**0 136 205**

Setting the forcing and settling conditions
This elemental specifies voltage and current values and time parameters that determine the PMU static and dynamic operating characteristics for a subsequent static test.

```
PMU-CONDITIONS    (V-FORCE     :    VOLTS;
                   V-RANGE      :    V-RNG-TYPE;
                   I-FORCE      :    AMPS;
                   I-RANGE      :    I-RNG-TYPE;
                   V-CONNECT    :    VOLTS;
                   USER-DELAY   :    DELAY-SECONDS
                   ROLL-OFF     :    COMPENSATION-TYPE);
```

V-FORCE is the signed value of the intended PMU operating voltage rail or voltage compliance for current rail operation. This value will be the intended voltage condition of test for a subsequent measurement or in conjunction with the I-FORCE value will determine the maximum power the PMU will deliver to, or drain from, a connected DUT load.

V-RANGE is either R128V, R64V, R32V, R16V, R8V, R4V, R2V, R1V, or BEST-FIT-V. The PMU voltage range for forcing and measurements.

I-FORCE is the signed value of the intended PMU operating current rail or a current compliance limit. This value will be the intended current condition of test for a subsequent PMU measurement or in conjunction with the V-FORCE value and a hardware current limit of equal value in the opposite quadrant to the one programmed, will determine a PMU power compliance limit for a connected DUT load.

I-RANGE is either R256MA, R128MA, R64MA, R32MA, R16MA, R8MA, R4MA, R2MA, R1MA, R512UA, R265UA, R128UA, R64UA, R32UA, R16UA, R8UA, R4UA, R2UA, R1UA, or R . 5UA. The PMU current range for forcing and measurements.

V-CONNECT is the user specified voltage to precharge the PMU connection path to before connection to the DUT. This voltage level must be within the V-RANGE and provide a connect condition to assure minimum disturbance of the DUT and a dry relay switch current when final connection to the DUT is made.

USER-DELAY is a user defined delay to wait after the PMU is gated on for a measurement. This delay is to provide adequate time for the PMU to settle to a final operating point before a GO-NO or RETURN-VALVE measurement is made. In the SMART settling type of test, the USER-DELAY specifies the maximum expected time for a worst case load to settle to a stable pass operating point. The programmed compensation, load, load capacitance, V-RANGE, I-RANGE, and desired accuracy of test are some factors that will determine the correct test settling time ·for the user to program.

ROLL-OFF is either NULL-COMP, COMP1, COMP2, or COMP3. The load capacitance in conjunction with the I-RANGE in use determines the roll off compensation to program. Generally the minimum roll off allowed for the I-RANGE is desirable to improve test throughput, but use of a marginal ROLL-OFF for the capacitive load expected may result in PMU oscillation.

Whenever the PMUPP range or resolution capabilities do not provide the desired test conditions, the PMU(s) should be used for static parameter measurements. The user can determine the minimum acceptable delay to use empirically during test plan debug by iteration of the USER-DELAY argument and tracking the measured value results. Changes of the performance board connections can cause changes in load capacity that may require adjustment of delay. Worst case delay estimates are provided in a tabular form in the product description.

This elemental load values to VTR and should precede a companion PMU-LIMITS elemental to provide necessary range checking. The values that are arguments of this elemental procedure are transferred to test hardware with the PMU-MEASURE execution elemental.

Specifying the connection to be used
This elemental controls the connection path for subsequent PMU measurements.

```
PMU-CONNECT    (PMU-REF     :    PMU-REFERENCE-TYPE;
                NUM-PMUS     :    NUM-PMUS-TYPE;
                FORCE        :    PMU-FORCE-TYPE);
```

PMU-REF is either DPS0, DPS1, DPS2, DPS3, DPS4, DPS5, or DGS. This argument defines the PMU reference as one of the DPS's or its default reference of Device Ground Sense.

NUM-PMUS is either ALL-PMUS or ONE-PMU. Where DUT test requirements demand a single PMU measurement be conducted at a time, the user may define ONE-PMU or use a default of ALL-PMUS and define a single pin PINGRP in the execution elemental.

FORCE is either FORCE-AND-MEASURE, or V-MEASURE-ONLY. This argument allows the PMU(s) to be used as a high impedance voltmeter instead of its normal application as a combined forcing and measuring device.

It is presumed that most PMU measurements will be performed using DGS as reference, ALL-PMUS, FAST-MATRIX and FORCE-AND-MEASURE. This combination of arguments is therefore the default state at

10

START time. If the user needs a change during test execution, he must invoke PMU-CONNECT prior to executing a measurement.

This elemental only loads virtual test resource values and must precede a companion PMU-MEASURE execution elemental if a change in default connect conditions is required. Restrictions, if any, when using a reference other than DGS are TBD. There may be some increase in required settling time and accuracy of force and measure will be relative to the accuracy of the DPS used as a reference.

Defining the pass window current limits

This elemental establishes a go/no-go current limit window for a subsequent PMU measurement.

PMU-I-LIMITS (I-MAX, I-MIN : AMPS);
I-MAX=upper current window limit.
I-MIN=lower current window limit.

PMU-I-LIMITS define a current limit window for PMU static test. The defined values must be within the range specified in the PMU-CONDITIONS elemental last executed. When this elemental is used, the condition of static test intended is assumed to be on the voltage rail defined in PMU-CONDITIONS and a one percent tolerance voltage limit window around the programmed voltage force value is automatically set by software. Thus, a PMU measurement that is strobed before analog settling of the PMU on the programmed voltage rail occurs will result in a fail decision. In this case the fail indicates the intended test conditions (voltage rail operation) were not met at the time the PMU sampled the voltage and current for an analog to digital conversion. A fail would also result if the PMU had settled on the voltage rail outside the defined current window pass limits. The latter case would be an out of limit test fail result.

I-MAX and I-MIN must be within the I-RNG programmed in the preceding PMU-CONDITIONS elemental. This elemental only loads VTR values and must precede a companion PMU-MEASURE execution elemental.

Specifying the pass conditions

This elemental is used to establish a bounded pass area for a subsequent PMU-MEASURE.

PMU-LIMITS     (V-MAX, V-MIN  : VOLTS;
               I-MAX, I-MIN   : AMPS);

V-MAX, V-MIN is the maximum and minimum voltage bounds of a pass area.

I-MAX, I-MIN is the maximum and minimum current bounds of a pass area.

This elemental is used when the user wants to define a PMU pass area that includes a voltage-current crossover corner of the PMU operating characteristic. For instance, a ten percent tolerance one kilo ohm resistor load to ground would have a pass area within ten percent of the crossover corner of a programmed one volt, one milliamp PMU operating characteristic.

Another possible reason to use the PMU-LIMITS instead of a PMU-I-LIMITS or PMU-V-LIMITS elemental is to change the default one percent tolerance applied by software on either side of the intended operating rail. Increasing the tolerance beyond one percent may allow faster measurements when the DUT static parameter to be measured has a minimal change near the desired condition of test. Decreasing the tolerance may require longer settling times but may be necessary to attain the desired accuracy of measurement.

Limit values must be within the ranges defined in a previously executed PMU-CONDITIONS elemental. This elemental only updates VTR values and must be executed prior to a companion PMU-MEASURE execution elemental.

Performing the measurement

This is the execution elemental for a PMU measurement. It automatically sequences the PMU through a pin list doing the predefined measurement sequence and returns a pass/fail decision and/or measured values.

PMU-MEASURE   (PIN-GROUP          :     PIN-GRP);
              MEASURE-METHOD :          MEASURE-METHOD-TYPE;

PIN-GROUP is a user defined pin group to be measured.

MEASURE-METHOD is either GO-NO, SMART, or RETURN-VALUE.

The basic PMU measurement sequence initiated for the GO-NO and RETURN-VALUE options is as follows. The relay matrix path to the Pin Electronics channel(s) to be measured is closed, predefined force and limit values, and compensation and delay registers are loaded. Before final connection to the DUT, the PMU is gated on forcing the connect voltage to precharge the connection path, then the current is gated off and the final Pin Electronic relay(s) is closed to connect to the DUT. The PMU Kelvin alarm is enabled by the elemental at this point in the sequence, and an abnormal test plan termination will result if a hardware fault

11

**0 136 205**

is detected that prohibits a Kelvin condition. The voltage forcing value is loaded and the PMu is gated on in current and voltage. The user defined delay timer countdown is initiated as any connected Pin Electronic driver or load circuits are relay disconnected to transfer the DUT load to the PMU. When the delay count down completes, sample and hold circuits are strobed to store voltage and current node values and the PMU's Analog to Digital Conversion (ADC) hardware is activated. Within 30 µs the digitized voltage and current ADC results are available for comparison to the preloaded limits. For a GO-NO measure method the digital compare result is a pass/fail decision. When a RETURN-VALUE measure method is defined, voltage, current and the compare result is stored in the global arrays RESULT-VOLTS, RESULT-AMPS AND RESULT-BOOLEAN respectively for the pins being measured. Once the PMU noted values have been sampled, while the ADC is digitizing, the PMU is programmed to the connect voltage, and after a minimal delay to settle, current is gated off. Pin electronic relays previously opened are closed. At this point, a fail decision at any pin(s) may abort the rest of the pin list without measurement unless the fail branch has been overridden. For a pass decision, the elemental continues through the pin list per 1 above or when the defined PIN-GROUP has successfully completed measurement the elemental relinquishes control to allow test plan continuation. For the SMART measure method, the ADC begins a continuous conversion process when the voltage and current are gated on. This ADC operation continues until the digitized results indicate an operating point within the pass area or the delay timer count down is completed. Any pass digitized result will allow the sequence to continue producing an optimum rate test sequence. If the delay countdown completes before a pass condition is digitized, the SMART measure method returns a fail result. This option provides an optimum test rate for low current tests that normally require long settling times. In this case the user should define a maximum allowable test time considering the current range, load capacity, compensation type, and expected accuracy. With other measure methods, the delay programmed will usually be trimmed to the minimum acceptable value that will result in the degree of accuracy required. For the SMART option, the delay programmed is the maximum time to settle under worst case conditions. When using the SMART option, test fail will require more test time than a pass which can proceed at optimum rate.

All necessary PMU program parameters are defined by prior PMU-CONDITIONS, PMU-CONNECT, and PMU-I-LIMITS or PMU-LIMITS or PMU-V-LIMITS elementals. The PMU-MEASURE places stored VTR values in hardware registers in the proper sequence to perform the desired test.

Hardware faults that prevent a Kelvin connection may cause abnormal termination of the test plan. Before normal testing can resume, the hardware fault must be corrected.


Specifying the pass window voltage limits

This elemental establishes a go/no-go voltage limit window on the programmed current rail for a subsequent PMU measurement.

PMU-V-LIMITS (V-MAX, V-MIN : VOLTS);
V-MAX is the upper voltage window limit.
V-MIN is the lower voltage window limit.

PMU-V-LIMITS define a voltage limit window for PMU static test. The defined values must be within the range specified in the PMU-CONDITIONS elemental last executed. When this elemental is used, the condition of the static test intended is assumed to be on the current rail defined in PMU-CONDITIONS and a one percent tolerance current limit window around the programmed current force value is automatically set by software. Thus a PMU measurement, that is strobed before analog settling of the PMU on the programmed current rail occurs, will result in a fail decision. In this case, the fail indicates the intended test conditions (current rail operation within one percent of programmed range) were not met at the time the PMU sampled the current for an analog to digital conversion. A fail would also result if the PMU had settled on the current rail condition of test outside the defined voltage window pass limits. The latter case would be an out of test limit fail result. If the user wishes other than a one percent current tolerance, PMU-LIMITS should be used.

V-MAX and V-MIN must be within the V-RNG programmed in the PMU-CONDITIONS elemental preceding. This elemental only loads values to a VTR and must precede a companion PMU-MEASURE execution elemental.

Fig. 5 shows the voltage-current capability of each PMU 20. If the current drawn by the load attempts to exceed the programmed value, the PMU 20 becomes a constant current source at the programmed value. Otherwise, the PMU 20 operates as a constant voltage source. The programmed voltage and current ranges are shown in Table II below. Each PMU 20 is capable of operating in one of two modes as follows: mode 1 (Fig. 5): ±100 V at ±128 mA (four quadrants) and mode 2 (Fig. 5): ±8 V at ±256 mA (four quadrants). The preferred voltage and current ranges of each PMU 20 are as follows:

12

**0 136 205**

TABLE II

PMU Voltage specification

| Range | Full scale (compliance) | Resolution | |
|---|---|---|---|
| | | Forced 13 bits+sign | Measured 11 bits+sign |
| 1 V | 1.049 V | 128 µV | 512 µV |
| 2 V | 2.097 V | 256 µV | 1.024 mV |
| 4 V | 4.194 V | 512 µV | 2.048 mV |
| 8 V | 8.389 V | 1.024 mV | 4.098 mV |
| 16 V | 16.777 V | 2.048 mV | 8.192 mV |
| 32 V | 33.554 V | 4.096 mV | 16.384 mV |
| 64 V | 67.109 V | 8.192 mV | 32.768 mV |
| 128 V | 134.218 V (100 V max) | 16.384 mV | 65.536 mV |

Accuracy force/measure: $\pm$(0.1% value+(1 count or 2.5 mV whichever is greater)).

TABLE II (Continued)

PMU Current specification

| Range | Full scale (compliance) | Resolution | |
|---|---|---|---|
| | | Forced 14 bits+sign | Measured 11 bits+sign |
| 0.5 µA | 0.512 µA | 250 pA | 250 pA |
| 1 µA | 1.024 µA | 250 pA | 500 pA |
| 2 µA | 2.048 µA | 250 pA | 1 nA |
| 4 µA | 4.096 µA | 250 pA | 2 nA |
| 8 µA | 8.192 µA | 500 pA | 4 nA |
| 16 µA | 16.384 µA | 1 nA | 8 nA |
| 32 µA | 32.768 µA | 2 nA | 16 nA |
| 64 µA | 65.536 µA | 4 nA | 32 nA |
| 128 µA | 131.072 µA | 8 nA | 64 nA |
| 256 µA | 262.144 µA | 16 nA | 128 nA |
| 512 µA | 524.288 µA | 32 nA | 256 nA |
| 1 mA | 1.049 mA | 64 nA | 512 nA |
| 2 mA | 2.097 mA | 128 nA | 1.024 nA |
| 4 mA | 4.194 mA | 256 nA | 2.048 µA |
| 8 mA | 8.389 mA | 512 nA | 4.096 µA |
| 16 mA | 16.777 mA | 1.024 nA | 8.192 µA |
| 32 mA | 33.554 mA | 2.048 µA | 16.384 µA |
| 64 mA | 67.109 mA | 4.096 µA | 32.768 µA |
| 128 mA | 132.218 mA | 8.192 µA | 65.536 µA |
| 256 mA | 268.435 mA | 16.394 µA | 131.072 µA |

| | |
|---|---|
| Accuracy force/measure: | ± (0.1% value+(1 count or 5 nanoamperes (nA) whichever is greater)). |
| Slew rate: | Voltage force mode, 1 V/microsecond minimum, all ranges. |
| Low side offset: | ±32 V, however, the output of the PMU 20 cannot exceed ±100 V with respect to ground. |

In summary, the PMU 20 is separately gated in current and voltage. Separate gating provides pre-conditioning prior to PMU 20 connection and a smooth transfer of the DUT load to the PMU for a measurement. The PMU 20 includes a digitally programmed source whose idle state (gated off) is preferably forcing zero volts with current rails set at one percent of full scale in the last programmed range. The digitally programmed source included in the PMU 20 is programmed with signed values of voltage and current to define two calibrated operating rails in the intended operating quadrant. An equal valued uncalibrated current rail in the opposite quadrant is automatically set by the circuitry to limit maximum power that can be delivered to the DUT. The connected DUT load determines a stable PMU 20 operating point (typically on the calibrated current or voltage rail) which can be digitized by the on-board ADC's included in the PMU after a programmed settling delay. The dynamic characteristics of the PMU 20 are under program control to optimize test throughput.

PMU 20 force lines can be open circuited by a relay under program control. In this configuration, the PMU 20 sense input can be routed as a high impedance voltmeter probe via the connect paths. The dedicated voltage and current ADC's can digitize measurements and return the values for software use, or compare these values to a programmed high and/or low limits which define a pass window to return a direct pass/fail result.

There are three different modes of PMU 20 application. A measured value for subsequent software use or data logging can be obtained by a measure command issued after connection to the DUT, gate-on, and an appropriate time out to settle to a final operating point has expired. The ADC's simultaneously convert the voltage and current values of the PMU 20 operating point. The two's complement ADC result is stored in registers, and an ADC complete signal is sent by the circuitry after the 50-microseconds conversion. The test head controller 12 then reads the registers and provides the values for the exact PMU 20 voltage and current operating point.

The on-board comparison means includes in the PMU 20 can be used to indicate a go/no-go decision based on DUT current demand greater than or less than a programmed limit. A go/no-go measurement is made in the same general sequence of events described above for obtaining a numerical result, except calibrated values are loaded into appropriate limit registers prior to issuing a measure command. Typically, only two or three of the four high and low voltage and current limit registers need to be loaded to assure a non-ambiguous go/no-go result. This application mode is faster than obtaining a numerical result since software decalibration of the measured results is not required.

Another go/no-go mode of PMU 20 application to DUT tests is referred to as analog settling analysis. This test has full hardware support and provides the fastest result for tests with long settling times, for example, when a low current is forced. All measurement modes can be used on voltage, current, or voltage and current simultaneously.

The device power supplies 18 are used to provide the DUT bias sources since all functions of the DC subsystem 16 are available to each test head 14. The PMU's 20 of the dedicated DC subsystem 16 can be applied for precision static test conditions and limits when the PMU 20 per pin ranges or accuracies are not acceptable. In either case, all types of static tests can be performed at one test head 14 while another test head is independently executing static or full rate functional tests on another DUT.

## Claims

1. A method for applying and monitoring a test signal at a node of a device under test including digitally programmed source means switchably connected by a first switch means to the node for supplying a test signal to the node and comparison means switchably connected by a second switch means to the node, the method comprising the steps of:

connecting the test signal to the node;

and characterized in that said source means has a preselected programmed voltage-current characteristic defined by not-to-exceed voltage rail and current rail levels and characterized by the steps of

comparing the test signal with a preselected programmed reference level;

providing an indication of the relative magnitude of the test signal with respect to the preselected programmed reference level; and

providing a preselected programmed constant signal in the event that the test signal has a predetermined relationship with respect to the programmed reference level.

2. The method of claim 1, characterized in that the step of comparing the test signal with a preselected programmed reference level comprises comparing the voltage applied to the node with the preselected programmed voltage rail level, the step of providing an indication of the relative magnitude of the test signal with respect to the preselected programmed reference level comprises providing an indication of the relative magnitude of the voltage applied to the node with respect to the voltage rail level, and the step of providing a preselected programmed constant signal in the event that the test signal has a predetermined relationship with respect to the preselected programmed reference level comprises applying the preselected programmed current rail level when the voltage applied to the node reaches the voltage rail level.

3. The method of claim 1, characterized in that the step of comparing the test signal with a preselected programmed reference level comprises comparing the current at the node with the preselected programmed current rail level, the step of providing an indication of the relative magnitude of the test signal with respect to the preselected programmed reference level comprises providing an indication of the relative magnitude of the current at the node with repect to the current rail level, and the step of providing a preselected programmed constant signal in the event that the test signal has a predetermined relationship

**0 136 205**

with respect to the preselected programmed reference level comprises applying the preselected program voltage rail level when the current at the node reaches the current rail level.

4. The method of claim 1, 2 or 3, characterized in that the test signal is a forcing function which starts at zero volts and one percent of the maximum current of a preselected voltage-current range.

5. Apparatus for applying and monitoring a test signal to a node of a device under test, comprising:
digitally programmed source means (20) switchably connected by a first switch means (K4) to the node;
comparison means (44) switchably connected by a second switch (K2) means to the node; and characterized by:
the source means (20) having a programmed voltage-current characteristic defined by not-to-exceed voltage rail and current rail levels for supplying test signals and alternatively a preselected programmed constant signal to the node; and
the comparison means (355, 357) indicating the relative magnitude of the test signal with respect to a preselected programmed reference level;
the digitally programmed source means (20) supplying the test signals unless the test signal applied has a predetermined relationship with respect to the preselected programmed reference level; and
the digitally programmed source means (20) supplying the preselected programmed constant signal in the event that the applied test signal has a predetermined relationship with respect to the preselected programmed reference level.

6. Apparatus as in claim 5, characterized in that the comparison means (357) compares the voltage applied to the node with the preselected programmed voltage rail level for providing an indication of the relative magnitude of the voltage applied to the node with respect to the voltage rail level; the digitally programmed source means (20) supplying the test signals unless the voltage applied to the node reaches the voltage rail level; the digitally programmed source means supplying the preselected programmed current rail level when the voltage applied to the node reaches the voltage rail level.

7. Apparatus as in claim 5, characterized in that the comparison means (355) compares the current at the node with the preselected programmed current rail level for providing an indication of the relative magnitude of the current at the node with respect to the current rail level; the digitally programmed source means (20) supplying the test signals unless the current at the node reaches the current rail level; the digitally programmed source means (20) supplying the preselected programmed voltage rail level when the current at the node reaches the current rail level.

8. Apparatus as in claim 5, 6 or 7, characterized in that the digitally programmed source means (20) is a crossover source which supplies a test signal in the form of a forcing function that starts at zero volts and one percent of the maximum current of a preselected voltage-current range.

9. A method for monitoring the response signal at a node of a device under test caused by a test signal applied to the node by digitally programmed source means switchably connected by a first switch means to the node and comparison means switchably connected by a second switch means to the node, the method comprising the steps of:
connecting the test signal to the node;
comparing the response signal voltage at the node with a first preselected programmed voltage level;
and characterized in that said source means has a preselected programmed voltage-current characteristic defined by not-to-exceed voltage rail and current rail levels and characterized by the steps of
comparing the response signal voltage at the node with a second preselected programmed voltage level;
comparing the response signal current at the node with a first preselected programmed current level;
comparing the response signal current at the node with a second preselected programmed current level;
providing an indication of the relative amplitude of the response signal voltage and current with respect to the first and second preselected programmed voltage levels and first and second preselected programmed current levels, respectively;
providing a pass signal when the response signal voltage and current have a first predetermined relationship with respect to the first and second preselected programmed voltage levels and first and second preselected programmed current levels, respectively; and
providing a fail signal when the response signal voltage and current have a second predetermined relationship with respect to the first and second preselected programmed voltage levels and first and second preselected programmed current levels, respectively;
thereby providing a non-ambiguous pass/fail result.

10. The method of claim 9, characterized in that the test signal is a forcing function which starts at zero volts and one percent of the maximum current of a preselected voltage-current range.

11. Apparatus for monitoring the response signal at a node of a device under test caused by a test signal applied to the node, comprising:
digitally programmed source means (20) switchably connected by a first switch means (K4) to the node;
first comparison means (357) switchably connected by a second switch means (K2) and characterized by:

16

the source means (20) having a programmed voltage-current characteristic defined by not-to-exceed voltage rail and current rail levels for supplying test signals to the node;

the first comparison means (357) indicating the relative amplitude of the response signal voltage at the node with respect to a first preselected programmed voltage level;

second comparison means (357) switchably connected by the second switch means to the node for indicating the relative amplitude of the response signal voltage at the node with respect to a second preselected programmed voltage level;

third comparison means (355) switchably connected by the second switch means to the node for indicating the relative amplitude of the response signal current at the node with respect to a first preselected programmed current level;

fourth comparison means (355) switchably connected by the second switch means to the node for indicating the relative amplitude of the response signal current at the node with respect to a second preselected programmed current level;

means (305) for providing a pass signal when the response signal voltage and current have a first predetermined relationship with respect to the first and second preselected programmed voltage levels and first and second preselected programmed current levels, respectively, and

providing a fail signal when the response signal voltage and current have a second predetermined relationship with respect to the first and second preselected programmed voltage levels and first and second preselected programmed current levels, respectively;

whereby a non-ambiguous pass/fail result is provided.

12. Apparatus as in claim 11, characterized in that the digitally programmed source means (20) is a crossover source which supplies a test signal in the form of a forcing function that starts at zero volts and one percent of the maximum current of a preselected voltage-current range.

**Patentansprüche**

1. Ein Verfahren zum Anlegen und Überwachen eines Prüfsignals an einen Verbindungspunkt eines Prüflings, einschließlich digital programmierter Quellenmittel, die über erste Umschaltmittel an den Verbindungspunkt anschaltbar sind zum Anlegen des Prüfsignals an den Verbindungspunkt, und Vergleichsmittel, die über zweite Umschaltmittel an den Verbindungspunkt anschaltbar sind, welches Verfahren die Schritte umfaßt:

Anlegen des Prüfsignals an den Verbindungspunkt;

und dadurch gekennzeichnet, daß die Quellenmittel eine vorgewählte programmierte Spannungs-Strom-Charakteristik aufweisen, definiert durch nicht-zu-überschreitende Spannungsstufen- und Stromstufenpegel, und gekennzeichnet durch die Schritte

Vergleichen des Prüfsignals mit einem vorgewählten programmierten Bezugspegel;

Vorsehen einer Anzeige der relativen Größe des Prüfsignals bezüglich des vorgewählten programmierten Bezugspegels; und

Vorsehen eines vorgewählten programmierten konstanten Signals im Falle, daß das Prüfsignal ein vorgegebenes Verhältnis bezüglich des programmierten Bezugspegels hat.

2. Das Verfahren nach Anspruch 1, dadurch gekennzeichnet, daß der Schritt des Vergleichens des Prüfsignals mit einem vorgewählten programmierten Bezugspegel das Vergleichen der an den Verbindungspunkt angelegten Spannung mit dem vorgewählten programmierten Spannungsstufenpegel umfaßt, der Schritt des Vorsehens einer Enzeige der relativen Größe des an den Verbindungspunkt angelegten Prüfsignals bezüglich des vorgewählten programmierten Bezugspegels das Vorsehen einer Anzeige der relativen Größe der an den Verbindungspunkt angelegten Spannung bezüglich des Spannungsstufenpegels umfaßt, und der Schritt des Vorsehens eines vorgewählten programmierten konstanten Signals in dem Fall, daß das Prüfsignal ein vorgegebenes Verhältnis bezüglich des vorgewählten programmierten Bezugspegels hat, das Anlegen des vorgewählten programmierten Stromstufenpegels, wenn die an den Verbindungspunkt angelegte Spannung den Spannungsstufenpegel erreicht, umfaßt.

3. Das Verfahren nach Anspruch 1, dadurch gekennzeichnet, daß der Schritt des Vergleichens des Prüfsignals mit einem vorgewählten programmierten Bezugspegel das Vergleichen des Stromes an dem Verbindungspunkt mit dem vorgewählten programmierten Stromstufenpegel umfaßt, der Schritt des Vorsehens einer Anzeige der relativen Größe des an den Verbindungspunkt angelegten Prüfsignals bezüglich des vorgewählten programmierten Bezugspegels das Vorsehen einer Anzeige der relativen Größe des Stromes an dem Verbindungspunkt bezüglich des Stromstufenpegels umfaßt, und der Schritt des Vorsehens eines vorgewählten programmierten konstanten Signals in dem Fall, daß das Prüfsignal ein vorgegebenes Verhältnis bezüglich des vorgewählten programmierten Bezugspegels hat, das Anlegen des vorgewählten programmierten Spannungsstufenpegels, wenn der Strom an dem Verbindungspunkt den Stromstufenpegel erreicht, umfaßt.

4. Das Verfahren nach Anspruch 1, 2 oder 3, dadurch gekennzeichnet, daß das Prüfsignal eine erzwungene Funktion ist, die bei Null Volt und einem Prozent des Maximalstroms eines vorgewählten Spannungs-Strom-Bereichs beginnt.

**0 136 205**

5. Vorrichtung zum Anlegen und Überwachen eines Prüfsignals an einen Verbindungspunkt eines Prüflings, umfassend:

digital programmierte Quellenmittel (20), die über erste Umschaltmittel (K4) an den Verbindungspunkt anschaltbar sind;

Vergleichsmittel (44), die über zweite Umschaltmittel (K2) an den Verbindungspunkt anschaltbar sind; und gekennzeichnet durch:

Die Quellenmittel haben eine programmierte Spannungs-Strom-Charakteristik, definiert durch nicht-zu-überschreitende Spannungsstufen- und Stromstufenpegel für die Lieferung von Prüfsignalen und, alternativ, eines vorgewählten programmierten konstanten Signals an den Verbindungspunkt; und

die Vergleichsmittel (355, 357) zeigen die relative Größe des Prüfsignals bezüglich eines vorgewählten programmierten Bezugspegels an;

die digital programmierten Quellenmittel (20) liefern die Prüfsignale, solange das angelegte Prüfsignal nicht ein vorgegebenes Verhältnis bezüglich des vorgewählten programmierten Bezugspegels hat; und

die digital programmierten Quellenmittel (20) liefern das vorgewählte programmierte konstante Signal in dem Fall, daß das angelegte Prüfsignal ein vorgegebenes Verhältnis bezüglich des vorgewählten programmierten Bezugspegels hat.

6. Vorrichtung wie in Anspruch 5, dadurch gekennzeichnet, daß die Vergleichsmittel (357) die an den Verbindungspunkt angelegte Spannung mit dem vorgewählten programmierten Spannungsstufenpegel vergleichen zum Vorsehen einer Anzeige der relativen Größe der an den Verbindungspunkt angelegten Spannung bezüglich des Spannungsstufenpegels; wobei die digital programmierten Quellenmittel (20) die Prüfsignale liefern, solange nicht die an den Verbindungspunkt angelegte Spannung den Spannungsstufenpegel erreicht; wobei die digital programmierten Quellenmittel den vorgewählten programmierten Stromstufenpegel liefern, wenn die an den Verbindungspunkt angelegte Spannung den Spannungsstufenpegel erreicht.

7. Vorrichtung wie in Anspruch 5, dadurch gekennzeichnet, daß die Vergleichsmittel (355) den Strom an dem Verbindungspunkt mit dem vorgewählten programmierten Stromstufenpegel vergleichen zum Vorsehen einer Anzeige der relativen Größe des Stromes an dem Verbindungspunkt bezüglich des Stromstufenpegels; wobei die digital programmierten Quellenmittel (20) die Prüfsignale liefern, solange nicht der Strom an dem Verbindungspunkt den Stromstufenpegel erreicht; wobei die digital programmierten Quellenmittel (20) den vorgewählten programmierten Spannungsstufenpegel liefern, wenn der Strom an dem Verbindungspunkt den Stromstufenpegel erreicht.

8. Vorrichtung wie in Anspruch 5, 6 oder 7, dadurch gekennzeichnet, daß die digital programmierten Quellenmittel (20) eine Überkreuz-Quelle sind, die ein Prüfsignal in Form einer erzwungenen Funktion liefert, die bei Null Volt und einem Prozent des Maximalstroms eines vorgegebenen Spannungs-Strom-Bereichs beginnt.

9. Ein Verfahren für das Überwachen des Reaktionssignals an einem Verbindungspunkt eines Prüflings, hervorgerufen durch ein an den Verbindungspunkt von digital programmierten Quellenmitteln angelegtes Prüfsignal, welche über erste Umschaltmittel an den Verbindungspunkt anschaltbar sind, und Vergleichsmittel, welche über zweite Umschaltmittel an den Verbindungspunkt anschaltbar sind, welches Verfahren die Schritte umfaßt:

Anlegen des Prüfsignals an den Verbindungspunkt;

Vergleichen der Reaktionssignalspannung an dem Verbindungspunkt mit einem ersten vorgewählten programmierten Spannungspegel;

und dadurch gekennzeichnet, daß die Quellenmittel eine vorgewählte programmierte Spannungs-Strom-Charakteristik aufweisen, definiert durch nicht-zu-überschreitende Spannungsstufen- und Stromstufenpegel, und gekennzeichnet durch die Schritte

Vergleich der Reaktionssignalspannung an dem Verbindungspunkt mit einem zweiten vorgewählten programmierten Spannungspegel;

Vergleich des Reaktionssignalstroms an dem Verbindungspunkt mit einem ersten vorgewählten programmierten Strompegel;

Vergleich des Reaktionssignalstroms an dem Verbindungspunkt mit einem zweiten vorgewählten programmierten Strompegel;

Vorsehen einer Anzeige der relativen Größe der Reaktionssignalspannung und des Reaktionssignalstroms bezüglich der ersten und zweiten vorgewählten programmierten Spannungspegel bzw. ersten und zweiten vorgewählten programmierten Strompegel;

Vorsehen eines Passiert-Signals, wenn die Reaktionssignalspannung ein erstes vorgegebenes Verhältnis bezüglich des ersten und zweiten vorgewählten programmierten Spannungspegels und der Reaktionssignalstrom ein erstes vorgegebenes Verhältnis bezüglich des ersten und zweiten vorgewählten programmierten Strompegels aufweisen; und

Vorsehen eines Versagt-Signals, wenn die Reaktionssignalspannung ein zweites vorgegebenes Verhältnis bezüglich des ersten und zweiten vorgewählten programmierten Spannungspegels und der Reaktionssignalstrom ein zweites vorgegebenes Verhältnis bezüglich des ersten und zweiten vorgewählten programmierten Strompegels aufweisen;

wodurch sich ein zweifelsfreies Passiert/Versagt-Resultat ergibt.

10. Das Verfahren des Anspruchs 9, dadurch gekennzeichnet, daß das Prüfsignal eine erzwungene

18

Funktion ist, die bei Null Volt und einem Prozent des Maximalstroms eines vorgewählten Spannungs-Strom-Bereichs beginnt.

11. Vorrichtung für die Überwachung des Reaktionssignals an einem Verbindungspunkt eines Prüflings, hervorgerufen durch ein an den Verbindungspunkt angelegtes Prüfsignal, umfassend:

digital programmierte Quellenmittel (20), die über erste Umschaltmittel (K4) an den Verbindungspunkt anschaltbar sind;

erste Vergleichsmittel (357), die über zweite Umschaltmittel (K2) an den Verbindungspunkt anschaltbar sind, und gekennzeichnet durch:

die Quellenmittel (20) haben eine programmierte Spannungs-Strom-Charakteristik, definiert durch nicht-zu-überschreitende Spannungsstufen- und Stromstufenpegel, für die Lieferung von Prüfsignalen an den Verbindungspunkt;

die ersten Vergleichsmittel (357) zeigen die relative Amplitude der Reaktionssignalspannung an dem Verbindungspunkt bezüglich eines ersten vorgewählten programmierten Spannungspegels an;

zweite Vergleichsmittel (357), die über die zweiten Umschaltmittel an den Verbindungspunkt anschaltbar sind, zum Anzeigen der relativen Amplitude der Reaktionssignalspannung an dem Verbindungspunkt bezüglich eines zweiten vorgewählte programmierten Spannungspegels;

dritte Vergleichsmittel (355), die über die zweiten Umschaltmittel an den Verbindungspunkt anschaltbar sind, zum Anzeigen der relativen Amplitude des Reaktionssignalstroms bezüglich eines ersten vorgewählten programmierten Strompegels;

vierte Vergleichsmittel (355), die über die zweiten Umschaltmittel an den Verbindungspunkt anschaltbar sind, zum Anzeigen der relativen Amplitude des Reaktionssignalstroms an dem Verbindungspunkt bezüglich eines zweiten vorgewählten programmierten Strompegels;

Mittel (305) zum Vorsehen eines Passiert-Signals, wenn die Reaktionssignalspannung ein erstes vorgegebenes Verhältnis bezüglich des ersten und zweiten vorgewählten programmierten Spannungspegels und der Reaktionssignalstrom ein erstes vorgegebenes Verhältnis bezüglich des ersten und zweiten vorgewählten programmierten Strompegels aufweisen; und

zum Vorsehen eines Versagt-Signals, wenn die Reaktionssignalspannung ein zweites vorgegebenes Verhältnis bezüglich des ersten und zweiten vorgewählten programmierten Spannungspegels und der Reaktionssignalstrom ein zweites vorgegebenes Verhältnis bezüglich des ersten und zweiten vorgewählten programmierten Strompegels aufweisen:

wodurch ein zweifelsfreies Passier/Versagt-Resultat erzielt wird.

12. Vorrichtung wie in Anspruch 11, dadurch gekennzeichnet, daß die digital programmierten Quellenmittel (20) eine Überkreuzquelle sind, die ein Prüfsignal in Form einer erzwungenen Funktion liefert, welche bei Null Volt und einem Prozent des Maximalstroms eines vorgewählten Spannungs-Strom-Bereichs beginnt.

**Revendications**

1. Procédé pour appliquer et surveiller un signal de test à un noeud d'un dispositif en cours de test comprenant des moyens d'alimentation programmés numériquement connectés au noeud de façon commutable par des premiers moyens de commutation et des moyens de comparaison connectés au noeud de façon commutable par des deuxièmes moyens de commutation, le procédé comprenant les étapes consistant à connecter le signal de test au noeud; caractérisé en ce que:

lesdits moyens d'alimentation ont une caractéristique tension-courant programmée présélectionnée, le procédé étant caractérisé par les étapes suivantes:

comparer le signal de test à un niveau de référence programmé présélectionné;

fournir une indication de l'amplitude relative du signal de test par rapport au niveau de référence programmé présélectioné; et

élaborer un signal constant programmé présélectionné dans le cas où le signal de test est une fonction prédéterminée du niveau de référence programmé.

2. Procédé selon la revendication 1, caractérisé en ce que l'étape de comparaison du signal de test à un niveau de référence programmé présélectionné consiste à comparer la tension appliquée au noeud à un niveau limite de tension programmé présélectionné, l'étape consistant à fournir une indication de l'amplitude relative du signal de test par rapport au niveau de référence programmé présélectionné consiste à fournir une indication de l'amplitude relative de la tension appliquée au noeud par rapport au niveau limite de tension, et l'étape d'élaboration d'un signal constant programmé présélectionné dans le cas où le signal de test est une fonction prédéterminée du niveau de référence programmé présélectionné consiste à appliquer le niveau limite de courant programmé prédéterminé lorsque la tension appliquée au noeud atteint le niveau limite de tension.

3. Procédé selon la revendication 1, caractérisé en ce que l'étape de comparaison du signal de test à un niveau de référence programmé présélectionné consiste à comparer le courant au noeud à un niveau limite de courant programmé présélectionné, l'étape consistant à fournir une indication de l'amplitude relative du signal de test par rapport au niveau de référence programmé présélectionné consiste à fournir une indication de l'amplitude relative du courant au noeud par rapport au niveau limite de courant, et l'étape d'élaboration d'un signal constant programmé présélectionné dans le cas où le signal de test est une

19

fonction prédéterminée du niveau de référence programmé présélectionné consiste à appliquer le niveau limite de tension programmé présélectionné lorsque le courant au noeud atteint le niveau limite de courant.

4. Procédé selon la revendication 1, 2 ou 3, caractérisé en ce que le signal de test est une fonction de forçage qui commence à zéro volt et un pour cent du courant maximal d'une gamme présélectionnée de tension-courant.

5. Dispositif pour appliquer et surveiller un signal de test à un noeud d'un dispositif en cours de test comprenant:

des moyens d'alimentation (20) programmés numériquement connectés au noeud de façon commutable par des premiers moyens de commutation (K4);

des moyens de comparaison (44) connectés au noeud de façon commutable par des deuxièmes moyens de commutation (K2); caractérisé en ce que:

les moyens d'alimentation (20) ont une caractéristique tension-courant programmée définie par des niveaux limites de tension et de courant à ne pas dépasser pour fournir alternativement au noeud des signaux de test et un signal constant programmé présélectionné;

les moyens de comparaison (355, 357) indiquent l'amplitude relative du signal de test par rapport à un niveau de référence programmé présélectionné;

les moyens d'alimentation programmés numériquement (20) fournissent les signaux de test à moins que le signal de test appliqué ne soit une fonction prédéterminée du niveau de référence programmé présélectionné; et

les moyens d'alimentation programmés numériquement (20) fournissent le signal constant programmé présélectionné dans le cas où le signal de test appliqué est une fonction prédéterminée du niveau de référence programmé présélectionné.

6. Dispositif selon la revendication 5, caractérisé en ce que les moyens de comparaison (357) comparent la tension appliquée au noeud au niveau limite de tension programmé présélectionné pour fournir une indication de l'amplitude relative de la tension appliquée au noeud par rapport au niveau limite de tension; les moyens d'alimentation (20) programmés numériquement fournissent les signaux de test à moins que la tension appliquée au noeud n'atteigne le niveau limite de tension; et les moyens d'alimentation programmés numériquement fournissent le niveau limite de courant programmé présélectionné lorsque la tension appliquée au noeud atteint le niveau limite de tension.

7. Dispositif selon la revendication 5, caractérisé en ce que les moyens de comparaison (355) comparent le courant appliqué au noeud au niveau limite de courant programmé présélectionné pour fournir une indication de l'amplitude relative du courant au noeud par rapport au niveau limite de courant; les moyens d'alimentation (20) programmés numériquement fournissent les signaux de test à moins que le courant au noeud n'atteigne le niveau limite de courant; et les moyens d'alimentation programmés numériquement fournissent le niveau limite de tension programmé présélectionné lorsque le courant au noeud atteint le niveau limite de courant.

8. Dispositif selon la revendication 5, 6 ou 7, caractérisé en ce que les moyens d'alimentation programmés numériquement (20) sont une alimentation quatre-quadrants qui fournit un signal de test sous la forme d'une fonction de forçage qui commence à zéro volt et à un pour-cent du courant maximal d'une gamme tension-courant présélectionné.

9. Procédé pour surveiller, à un noeud d'un dispositif en cours de test, le signal de réponse causé par un signal de test appliqué au noeud par des moyens d'alimentation programmés numériquement connectés au noeud de façon commutable par des premiers moyens de commutation, et des moyens de comparaison connectés au noeud de façon commutable par des deuxièmes moyens de commutation, le procédé comprenant les étapes suivantes:

connecter le signal de test au noeud;

comparer la tension du signal de réponse au noeud à un premier niveau de tension programmé présélectionné;

caractérisé en ce que lesdits moyens d'alimentation ont une caractéristique tension-courant programmée présélectionné définie par des niveaux limites de tension et de courant à ne pas dépasser et caractérisé par les étapes suivantes:

comparer la tension du signal de réponse au noeud à un deuxième niveau de tension programmé présélectionné;

comparer le courant du signal de réponse au noeud à un premier niveau de courant programmé présélectionné;

comparer le courant du signal de réponse au noeud à un deuxième niveau de courant programmé présélectionné;

fournir une indication de l'amplitude relative de la tension et du courant du signal de réponse par rapport respectivement aux premier et deuxième niveaux de tension programmés présélectionnés;

fournir un signal de succès lorsque la tension et le courant du signal de réponse sont une première fonction prédéterminée respectivement des premier et deuxième niveaux de tension programmés prédéterminés et des premier et deuxième niveaux de courant programmés prédéterminés; et

fournir un signal d'échec lorsque la tension et le courant du signal de réponse sont une deuxième fonction prédéterminée, respectivement des premier et deuxième niveaux de tension programmés

**0 136 205**

prédéterminés et des premier et deuxième niveaux de courant programmés prédéterminés;

fournissant ainsi un résultat non ambigu de succès ou d'échec.

10. Procédé selon la revendication 9, caractérisé en ce que le signal de test est une fonction de forçage qui commence à zéro volt et à un pour-cent du courant maximal d'une gamme tension-courant présélectionnée.

11. Dispositif pour surveiller, à un noeud d'un dispositif en cours de test, le signal de réponse causé par un signal de test appliqué au noeud, comprenant:

des moyens d'alimentation programmés numériquement (20) connectés au noeud de façon commutable par des premiers moyens de commutation (K4);

des premiers moyens de comparaison (357) connectés de façon commutable par des deuxièmes moyens de commutation (K2) caractérisés en ce que:

les moyens d'alimentation (20) ont une caractéristique tension-courant programmée définie par des niveaux limites de tension et de courant à ne pas dépasser pour fournir les signaux de test au noeud;

les premiers moyens de comparaison (357) indiquent l'amplitude relative de la tension du signal de réponse au noeud par rapport à un premier niveau de tension programmé présélectionné; et en ce qu'il comprend:

des deuxièmes moyens de comparaison (357) connectés au noeud de façon commutable par les deuxièmes moyens de commutation pour indiquer l'amplitude relative de la tension du signal de réponse au noeud par rapport à un deuxième niveau de tension programmé présélectionné;

des troisièmes moyens de comparaison (355) connectés au noeud de façon commutable par les deuxièmes moyens de commutation pour indiquer l'amplitude relative du courant du signal de réponse au noeud par rapport à un premier niveau de courant programmé présélectionné;

des quatrièmes moyens de comparaison (355) connectés au noeud de façon commutable par les deuxièmes moyens de commutation pour indiquer l'amplitude relative du courant du signal de réponse au noeud par rapport à un deuxième niveau de courant programmé présélectionné;

des moyens (305) pour fournir un signal de succès lorsque la tension et le courant du signal de réponse sont une première fonction prédéterminée, respectivement, des premier et deuxième niveaux de tension programmés présélectionnés et des premier et deuxième niveaux de courant programmés présélectionnés; et

pour fournir un signal d'échec lorsque la tension et le courant du signal de réponse sont une deuxième fonction prédéterminée respectivement des premier et deuxième niveaux de tension programmés présélectionnés et des premier et deuxième niveaux de courant programmés présélectionnés;

de façon à fournir ainsi un résultat non ambigu de succès ou d'échec.

12. Dispositif selon la revendication 11, caractérisé en ce que les moyens d'alimentation programmés numériquement (20) sont une alimentation quatre-quadrants qui fournit un signal de test sous la forme d'une fonction de forçage qui commence à zéro volt et à un pour-cent du courant maximal d'une gamme tension-courant présélectionnée.

21

FIG._1.

0 136 205

FIG._2.

2

FIG.__3.

0 136 205

FIG._4.

FIG._5.